# EUROPEAN PATENT APPLICATION

(11) **EP 4 340 045 A1**
(43) Date of publication of application: **20.03.2024**
(21) Application number: 23197020.3
(22) Date of filing: 12.09.2023
(51) Int. Cl.: H01L 29/861, H01L 29/06, H01L 21/329, H01L 27/02

(54) **BIDIRECTIONAL ASYMMETRIC TRANSIENT VOLTAGE SUPPRESSOR DEVICE**

(30) Priority: 16.09.2022 CN 202211129583
(71) Applicant: Littelfuse Semiconductor (Wuxi) Co., Ltd., Wuxi, Jiangsu 214142 (CN)
(72) Inventor: Rosensaft, Boris, Wuxi, 214142 (CN); Steinhoff, Stefan, Wuxi, 214142 (CN); Gu, Xingchong, Wuxi, 214142 (CN)
(74) Representative: Arnold & Siedsma

(57) **Abstract**

A transient voltage suppression (TVS) device and method of formation. A TVS device may include a first layer, disposed on a first surface of a substrate, comprising a first P+ layer; a second layer, disposed on a second surface of the substrate, opposite the first surface, comprising a second P+ layer; a third layer, disposed between the first P+ layer and the second P+ layer, comprising an N- layer; and an isolation diffusion region, comprising a P structure, connected to the second P+ layer, and extending along a perimeter of the N- layer.

## Description

### Background

### Field

Embodiments relate to the field of circuit protection devices, including transient voltage suppressor devices.

### Discussion of Related Art

Semiconductor devices such as transient voltage suppressor (TVS) devices may be fabricated as unidirectional devices or bidirectional devices. In many applications, TVS diodes may be used to protect the sensitive circuit nodes against one-time and time-limited overvoltage faults. Such TVS diodes are also used in modern high power IGBT circuits to protect against overload in the collector circuit. The requirements for such TVS diodes may include a high breakdown voltage, with low deviation and low temperature coefficient, as well as a high surge current capability, with a low clamping voltage. In present day technology, two or more low voltage TVS diodes are arranged in series to achieve the voltage range from roughly 500 V. Such series connection is both costly and thermally ineffective. Low Voltage TVS diodes having a mesa or moat termination are less suitable for high voltage TVS applications, because the E-field distribution in such devices exhibits a maximum near a passivation material, which maximum causes a strong deviation of the breakdown voltage and a high leakage current.

With respect to these and other considerations, the present disclosure is provided.

### Summary

In one embodiment, a TVS device may include a first layer, disposed on a first surface of a substrate, comprising a first P+ layer. The TVS device may also include a second layer, disposed on a second surface of the substrate, opposite the first surface, comprising a second P+ layer. As such, the TVS device may include a third layer, disposed between the first P+ layer and the second P+ layer, comprising an N- layer. The TVS device may further include an isolation diffusion region, comprising a P structure, connected to the second P+ layer, and extending along a perimeter of the N- layer.

In a further embodiment, an asymmetric bidirectional transient voltage suppression (TVS) device is provided. The asymmetric bidirectional TVS device may include a semiconductor substrate, having a first main surface, a main second surface, opposite to the first main surface, and a set of side surfaces. The asymmetric bidirectional TVS device may include a first layer, disposed on the first main surface, and comprising a first polarity, and a second layer, disposed on the second main surface, and comprising the first polarity. The asymmetric bidirectional TVS device may further include a third layer, comprising a second polarity and being disposed within a bulk of the substrate, and being disposed between and in contact with the first layer and the second layer. The asymmetric bidirectional TVS device may also include an isolation diffusion region, comprising a doped material having the first polarity, the isolation diffusion region being disposed along the set of side surfaces, connected to the second layer, and extending along a perimeter of the third layer.

In another embodiment, a method of forming an asymmetric bidirectional TVS device may include providing an N- substrate, and forming an isolation diffusion region along a perimeter of the N- substrate, comprising a P- material, by diffusing a P-type dopant from a second main surface of the N- substrate. The method may include forming a first layer on a first main surface of the substrate, comprising a first P+ layer, and forming a second layer on a second main surface of the substrate, opposite the first surface, comprising a second P+ layer. As such, an N-layer is formed between the first P+ layer and the second P+ layer, and the isolation diffusion region is electrically isolated from the first P+ layer.

### Brief Description of the Drawings

**FIG. 1** **one** implementation of a TVS diode arranged in a circuit with a high power IGBT circuit to protect against overload in a collector circuit;
**FIG. 2** illustrates a TVS device according to embodiments of the disclosure;
**FIG.2A** depicts a two-dimensional map of the electric field strength in reverse blocking mode for the TVS device of FIG. 2;
**FIG. 3** shows an exemplary current-voltage (I-V) characteristic for a TVS device, arranged according to embodiments of the disclosure;
**FIG. 4** illustrates a TVS device according to other embodiments of the disclosure;
**FIG. 5** illustrates another TVS device according to further embodiments of the disclosure;
**FIG. 6** illustrates a further TVS device according to additional embodiments of the disclosure;
**FIG. 7** depicts experimentally measured reverse I-V behavior of an asymmetrical bidirectional high voltage TVS device, arranged generally according to the embodiment of FIG. 2;
**FIG. 8** presents an exemplary process flow;
**FIG. 9** presents an exemplary process flow; and
**FIG. 10** presents an exemplary process flow.

### Description of Embodiments

The present embodiments will now be described more fully hereinafter with reference to the accompanying drawings, in which exemplary embodiments are shown. The embodiments are not to be construed as limited to the embodiments set forth herein. Rather, these embodiments are provided so that this disclosure will be thorough and complete, and will fully convey their scope to those skilled in the art. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements.

In various embodiments, novel device structures and techniques are provided for forming a bidirectional TVS device.

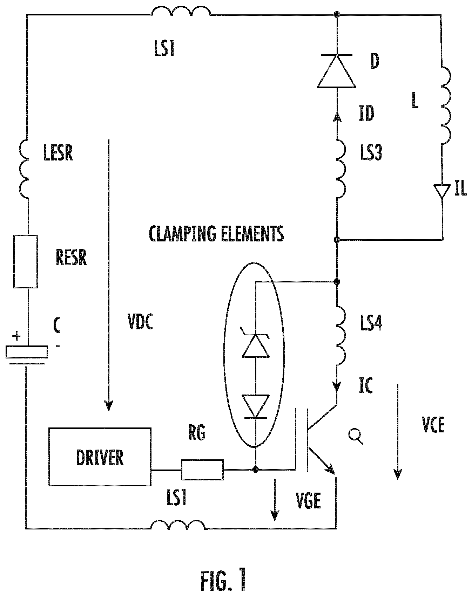

**FIG. 1** illustrates one implementation of a TVS diode arranged in a circuit with a high power IGBT circuit to protect against overload in the collector circuit, providing IGBT Active Clamping.

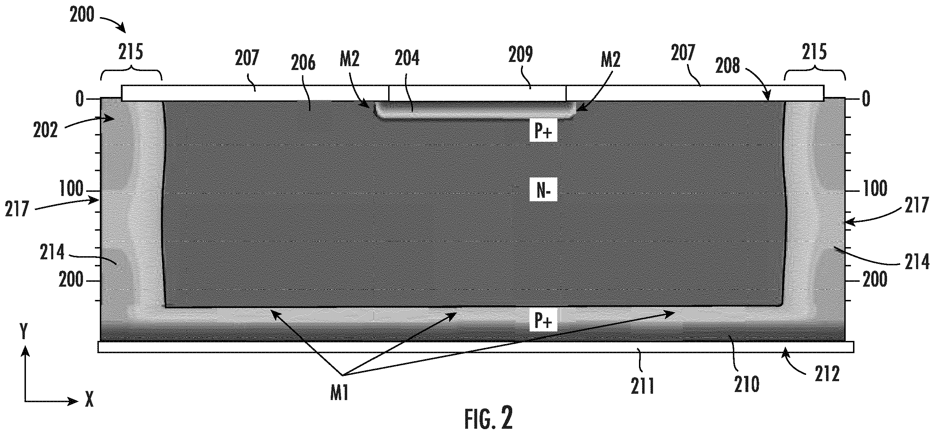

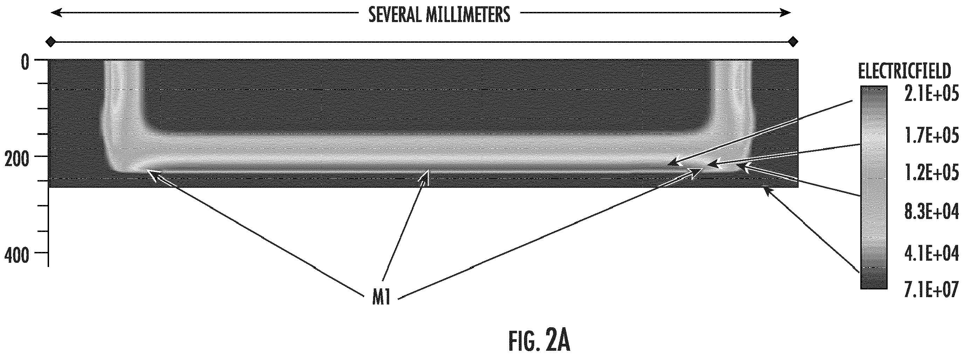

**FIG. 2** illustrates a TVS device 200, arranged in accordance with embodiments of the disclosure. This embodiment, and others to follow, is based on the approach to form a monolithic bidirectional asymmetric TVS diode to meet high voltage requirements. In brief, in the present embodiments, an NPT (non-punch-through) P+N-P+ structure may be formed in a semiconductor die that is also provided with an isolation diffusion edge termination, thus forming a monolithic device suitable for high voltage TVS applications.

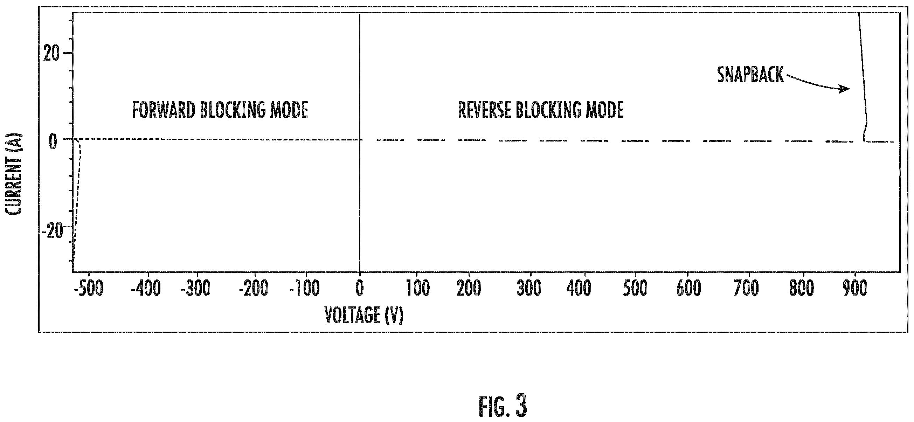

By way of reference, known low voltage TVS devices may formed with various types of isolation structures that may include passivation in the form of moat or mesa edge termination. Note that such devices may not be suitable for high voltage TVS applications, because the E-field distribution exhibits maximums near the passivation, which would cause a strong deviation of the breakdown voltage and high leakage current. With reference to FIG. 3, there is shown an exemplary current-voltage (I-V) characteristic for the TVS device 200. The active clamping function of the TVS device 200 corresponds to the reverse blocking direction ("+" on cathode and "-" on anode). As detailed below, the structure of the TVS device 200, including the use of the back-sided isolation diffusion, generates a low deviation of the breakdown voltage in the reverse direction possible, because the maximum electric field is placed in a bulk region of the semiconductor body. Moreover, the use of the NPT P+N-P+ structure provides other important advantages, such as a low clamping voltage with low power losses during a surge current event, as well as a low thermal coefficient of the breakdown voltage. The first advantage occurs as a result of the negative dynamic resistance exhibited in the reverse blocking mode (see snapback region of FIG. 3). The snapback behavior exhibited in FIG. 3 is caused by transistor gain of the PNP structure, which gain depends on current value. This effect is made possible by possible by engineering the electric field plateau maxima (M1) in reverse blocking mode to be located in the Si bulk (meaning in this example, M1 are located in the lower P+N- junction well away (hundreds of micrometers) to isolation diffusion region) as detailed below.

Turning again to **FIG. 2****,** the TVS device 200 may be formed in a monolithic semiconductor die, which die is represented by substrate 202. The TVS device 200 may include a first layer 204, disposed on a first main surface 208 of the substrate 202, where the first layer may be a first P+ layer. The TVS device 200 may further include a second layer 210, disposed on a second main surface 212 of the substrate 202, opposite the first main surface 208, where the second layer constitutes a second P+ layer. As used herein, the terms 'P+' or 'P+ layer' may refer to a region in a semiconductor substrate having a surface concentration of p dopant generally in the range of 1E17cm⁻³ -1E21cm⁻³.

The TVS device 200 may further include a third layer 206, disposed between the first P+ layer and the second P+ layer, where the third layer 206 is an N- layer. The TVS device 200 may also include an isolation diffusion region 214, comprising a P layer, connected to the second P+ layer, and extending along a perimeter of the N- layer. As used herein, the terms 'P' or `P layer' may refer to a region in a semiconductor substrate having a surface concentration of p dopant generally in the range of 5E16 cm⁻³ - 1E18 cm. As such, the isolation diffusion region 214 forms an isolation diffusion edge termination for the device structure of FIG. 2. Note that the isolation diffusion region 214 may be formed by diffusing dopant from a border region 215 of a wafer before dicing of the wafer to form the substrate 202. The border region may correspond to a surface grid pattern that defines a die or chip edges (shown as side 217) on the surface of a semiconductor wafer before dicing. As such, the border region will represent a region of a semiconductor substrate that extends above the side surfaces of semiconductor die after dicing.

In the embodiment of **FIG. 2****,** the isolation diffusion region 214 extends from the second main surface 212 to the first main surface 208, while the first P+ layer (first layer 204) extends over just a first portion of the first main surface 208. The N- layer (third layer 206) extends over a second portion of the first main surface 208 that surrounds the first layer 204, so that the first P+ layer is electrically isolated from the isolation diffusion region 214 that extends on the perimeter of the substrate 202. The TVS device 200 may further include a top passivation layer 207, such as an oxide layer and a top electrode contact 209 (ME1), such as a metal contact, formed in an opening of the top passivation layer 207. Additionally, a bottom electrode contact 211 (ME2) may be formed as a blanket layer on the second main surface 212.

FIG. 2 also provides an indication of the position of electric field maxima during operation of the TVS device 200. The plateau maxima M1 indicate the location of the electric field maximum for operation of the TVS device 200 in reverse bocking direction (active clamping mode). Note that M1 may always be located in P+N- junction (between N- region and P+ second layer 210) because of the asymmetric (P/P⁺) -N⁻ junction. To illustrate this phenomenon more clearly, **FIG. 2A** provides a two-dimensional cross-sectional map showing a simulation of the electric field strength in the TVS device 200 in reverse blocking mode, where field strength is plotted as a function of position according to the Cartesian coordinate system shown. Note that the distance along the Y axis is in micrometers, while the width of the TVS device 200 along the X axis may correspond to several millimeters of more. As shown in FIG. 2A, the maxima M1 are located in the PIN junction and form a plateau extending along the X-axis (see FIG. 2). Note that the lateral distance of M1 (along the X-axis) from the edge of the isolation diffusion region 214 may be on the order of hundreds of micrometers.

The maxima M2 indicate the location of the electric field maximum for operation of the TVS device 200 in forward bocking direction. Note that M2 may always located in the curved edge of the P+N- junction between first P⁺ layer (first layer 204) and N- layer due to PN junction curvature.

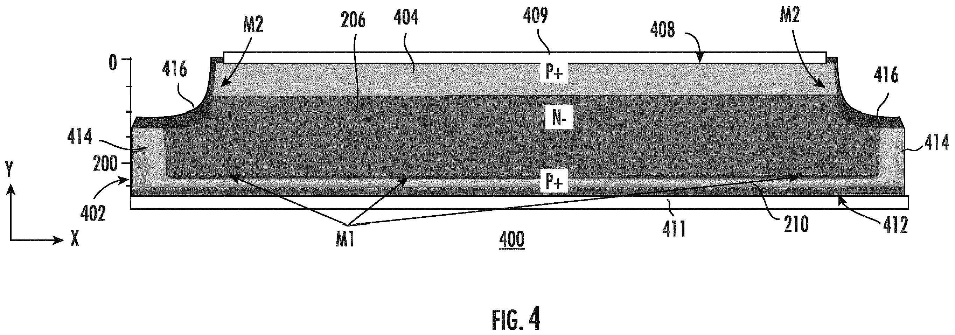

Turning now to **FIG. 4****,** there is shown a TVS device 400, arranged within a substrate 402 in accordance with other embodiments of the disclosure. In this example, in addition to an isolation diffusion region 414, surrounding the third layer 206, isolation is provided by a mesa structure of mesa isolation region 416, extending from the first surface 408. The mesa isolation region 416 is designed to surround the first P+ layer, meaning the first layer 404, where the mesa isolation region 416 is also disposed in contact with the isolation diffusion region 414. The mesa isolation region 416 may be formed by known operations, including operations to mask, etch and form an insulator material for the mesa isolation region 416, such as an oxide. The TVS device 400 may further include a top electrode contact 409 (ME1), such as a metal contact, formed in the first surface 408 in a region bounded by mesa isolation region 416. Additionally, a bottom electrode contact 411 (ME2) may be formed as a blanket layer on the second surface 412.

As in the TVS device 200, the reverse blocking mode maxima shown as M1 may be located in the lower P+N- junction (between N- region and second layer 210) well away (hundreds of micrometers) to isolation diffusion region). The forward blocking mode maxima shown as M2 may be located near (several micrometers or less) to the passivation layer of mesa isolation region 416, due to strong depletion layer bending close to the passivation layer.

A major advantage of this structure is that the depth of the isolation diffusion is defined by MESA depth. In other words, because the isolation diffusion region 414 abuts against the bottom of the mesa isolation region 416, the isolation diffusion region 414 will need only extend from the second surface 412 to the depth necessary to reach the mesa isolation region 416. Accordingly, this design allows the reduction of the isolation diffusion depth by increasing the MESA depth, and thus reducing the needed depth for diffusing dopants from the second surface, and thus a reduction in dopant diffusion time and lowered process costs therewith.

A related advantage of this design is that the isolation diffusion region 414 may be formed by diffusing a P-type dopant, just from the second main surface 212, as compared to the isolation diffusion region 214 of the embodiment of FIG. 2, which region is formed in practical implementations by diffusing a P-type dopant from the first main surface 208, as well as from the second main surface 212. Another advantage of this design is that the first P+ layer, first layer 404, is inherently electrically isolated from the isolation diffusion region 414 by virtue of the insulator material of the mesa isolation region 416. Thus, the first layer 404 may be formed over an entirety of the first main surface 208, within the mesa isolation region 416 as shown, such that no masking operations are required to form a smaller P+ region, as in the embodiment of FIG. 2.

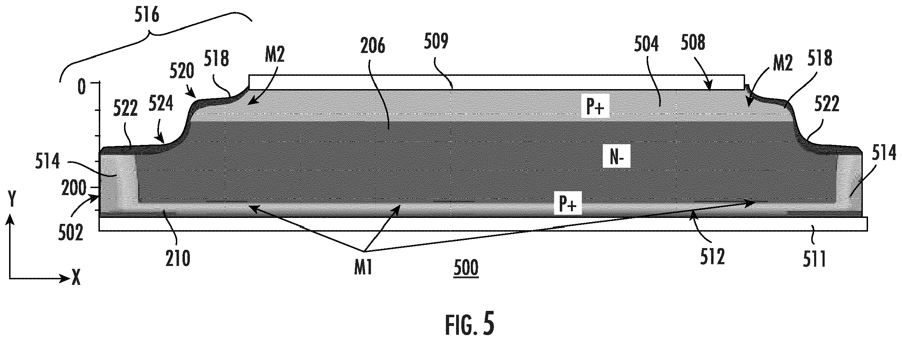

Turning now to **FIG. 5****,** there is shown a TVS device 500, arranged within a substrate 502 in accordance with other embodiments of the disclosure. In this example, in addition to an isolation diffusion region 514, surrounding the third layer 206, isolation is provided by another structure, shown as mesa isolation region 516, extending from the first surface 508. The mesa isolation region 516 is also designed to surround the first P+ layer, meaning first layer 504, where the mesa isolation region 516 is disposed in contact with the isolation diffusion region 514. The mesa isolation region 516 may be formed by known operations, including operations to form an insulator material for the mesa isolation region 516, such as an oxide. In this example, the mesa isolation region has a two-step mesa structure: a first step 518 of the mesa isolation region 516 has a lower surface 520 formed within the first P+ layer, and a second step 522 of the mesa isolation region 516 has a lower surface 524 formed within the N- layer. This structure facilitates a better blocking capability in the forward blocking direction ("-" on cathode and "+" on anode).

The TVS device 500 may further include a top electrode contact 509 (ME1), such as a metal contact, formed in the first surface 508 in a region bounded by mesa isolation region 516. Additionally, a bottom electrode contact 511 (ME2) may be formed as a blanket layer on the second surface 512.

As in the TVS device 200, and TVS device 400, the reverse blocking mode maxima shown as M1 may be located in the lower P+N- junction (between N- region and second layer 210) well away (hundreds of micrometers) to isolation diffusion region

In addition to the advantages of the design of FIG. 4, in this design, the E-field distribution maximum for forward block mode, shown as M2, is located well away (tens of micrometers) from the passivation provided by the mesa isolation region 516. This geometry facilitates lower leakage current during operation and higher breakdown voltage.

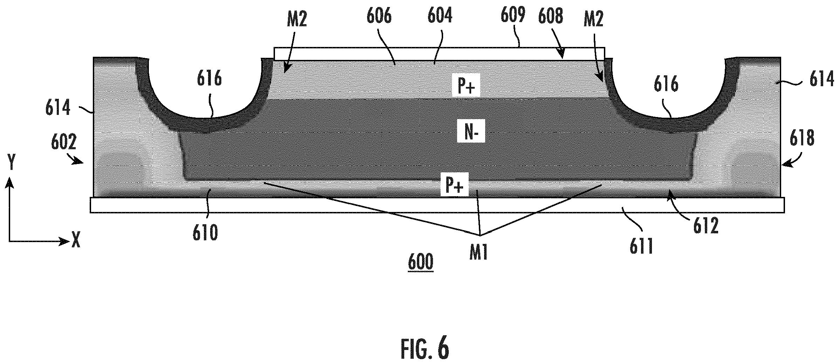

Turning now to **FIG. 6****,** there is shown a TVS device 600, arranged within a substrate 602 in accordance with additional embodiments of the disclosure. In this example, in addition to an isolation diffusion region 614, surrounding a third layer 606 (N- layer), isolation is further provided by a moat structure, shown as moat isolation region 616, extending from the first surface 608 into the N- layer. The moat isolation region 616 also surrounds the first P+ layer (first layer 604), in a manner where the moat isolation region 616 is disposed in contact with the isolation diffusion region 614. The moat isolation region 616 may be formed by known operations, including operations to mask, etch and form an insulator material for the moat isolation region 616, such as an oxide.

The TVS device 600 may further include a top electrode contact 609 (ME1), such as a metal contact, formed in the first surface 608 in a region bounded by moat isolation region 616. Additionally, a bottom electrode contact 611 (ME2) may be formed as a blanket layer over a second P+ layer (second layer 610) on the second surface 612.

As in the TVS device 200, the reverse blocking mode maxima plateau shown as M1 may be located in P+N- junction (between N- layer (third layer 606) and second layer 610) in the distance of hundreds of micrometers from the edge of the isolation diffusion region 614. The forward blocking mode maxima shown as M2 may be located near (several micrometers or less) to the passivation layer of moat isolation region 616, due to strong depletion layer bending close to the passivation layer.

As shown in FIG. 6, the moat isolation region 616 may be formed away from an edge 618 of the substrate 602. As an example, the substrate 602 may represent a semiconductor die after having been cut or diced from a larger semiconductor wafer. An advantage of this design is that the isolation diffusion region 614 may be formed by diffusing a P-type dopant, just from the second main surface 212, as compared to the isolation diffusion region 214, as discussed previously. Another advantage of this design is that the first P+ layer, first layer 604 is inherently electrically isolated from the isolation diffusion region 614 by virtue of the insulator material of the moat isolation region 616. Thus, the first layer 604 may be formed over an entirety of the first main surface 208 within the area surrounded by the moat isolation region 616 as shown, such that no masking operations are required to form a smaller P+ region, as in the embodiment of FIG. 2. A further advantage of the design of FIG. 6 is that the operations such as dicing, used to form the edge 618 of the substrate 602 are located well away from the insulator material of the moat isolation region 616, preventing dicing from taking place through the insulator material, which operation may tend to generate defects.

In summary, the embodiments of TVS devices discussed with respect to FIGs. 2-6 provide configurations of P+/N-/P+ layers with isolation diffusion regions that will exhibit lower transistor gain than the gain of a known P/N/P device structure. However, depending upon the details of the design, these P+N-P+ structures may exhibit undue increased hot leakage current in the reverse direction, due to the current amplification of the P+N-P+ structure.

In additional embodiments of the disclosure, any of these aforementioned structures may be modified to reduce hot leakage current by choosing the correct thickness of the N- layer, for example. The higher the thickness of the N- layer the lower PNP transistor gain. The lower the transistor gain the lower the leakage current of PNP structure.

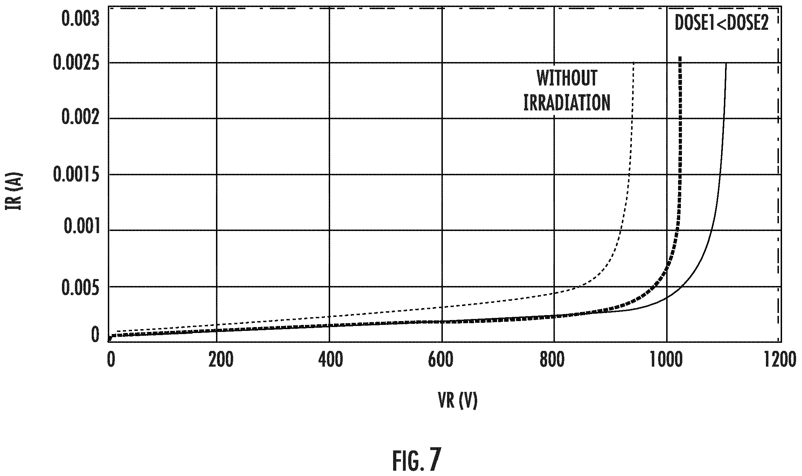

In further embodiments of the disclosure, the hot leakage may be further reduced by irradiation of a device using electrons. FIG. 7 is a graph showing the experimentally measured reverse I-V behavior of an asymmetrical bidirectional high voltage TVS device, arranged generally according to the embodiment of FIG. 2. The leftmost curve illustrates I-V characteristics for an unirradiated device structure, while the middle curve illustrates the I-V characteristics for the device structure after irradiation with a relatively lower dose of electrons, and the rightmost curve illustrates the I-V characteristics for the device structure after irradiation with a relatively higher dose of electrons. As illustrated, the use of electron irradiation substantially reduces the leakage current at 600 V, for example, and also increases the breakdown voltage substantially, by 100V or more at the 150 °C measurement temperature. According to various embodiments of the disclosure, a range of electron dose effective to reduce leakage and increase breakdown voltage may be between 0.2 kGy-20 kGy.

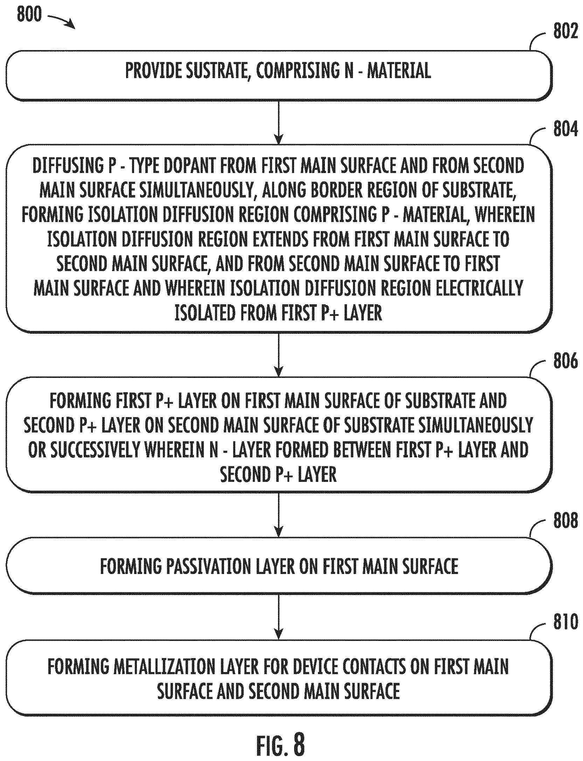

**FIG. 8** presents an exemplary process flow 800. At block 802 a substrate is provided, where the substrate is formed of a N- material, meaning the substrate is a semiconductor material that is doped with a N-type dopant at a surface concentration in a range of 5E13 cm⁻³ - 1E15 cm⁻³.

At block 804, a P-type dopant is diffused from the first main surface and second main surface of the semiconductor substrate, into the bulk of the semiconductor substrate along a border region of the substrate, thus forming an isolation diffusion region comprising P- material that extends from the first main surface to the second main surface. In some examples, the dopant is diffused simultaneously from the first main surface and the second main surface. As such, the isolation diffusion region may be electrically isolated from the first P+ layer by virtue of a region of the first main surface that is formed of N- material surrounding the first P+ layer.

At block 806, a first P+ layer is formed on a first main surface of the substrate. The first P+ layer may have a P-type dopant surface concentration in a range of 1E17 cm⁻³ -1E21 cm⁻³. The first P+ layer may be formed over just a first region of the first main surface, such that in a second region of the first main surface, the N-material of the substrate remains. In one example, the first region of the first main surface may correspond to a plurality of cathode regions on a silicon wafer corresponding to a plurality of TVS die to be formed. As such, the device formed may represent a P+NP+ non-punch through TVS device with low deviation of the breakdown voltage in the reverse direction, because the structure places the maximum electric field in a bulk region of the semiconductor body. In some embodiments, forming of a second P+ layer on a second main surface of the substrate takes place simultaneously or in succession with the forming of the first P+ layer. As such an N- layer is formed in a bulk region of the substrate between the first P+ layer and second P+ layer. In some examples, the second P+ layer may be formed in blanket fashion over an entirety of the second main surface.

At block 808, a passivation layer such as an oxide is formed on the first main surface. At block 810, metal contact layers are formed on the first main surface and the second main surface. In one example, a metal contact may be formed in an opening on the first main surface, such as above the first P+ layer to form a first electrode contact. In some examples, a blanket metal contact may be formed on the second main surface to form a second electrode contact in contact with the second P+ layer.

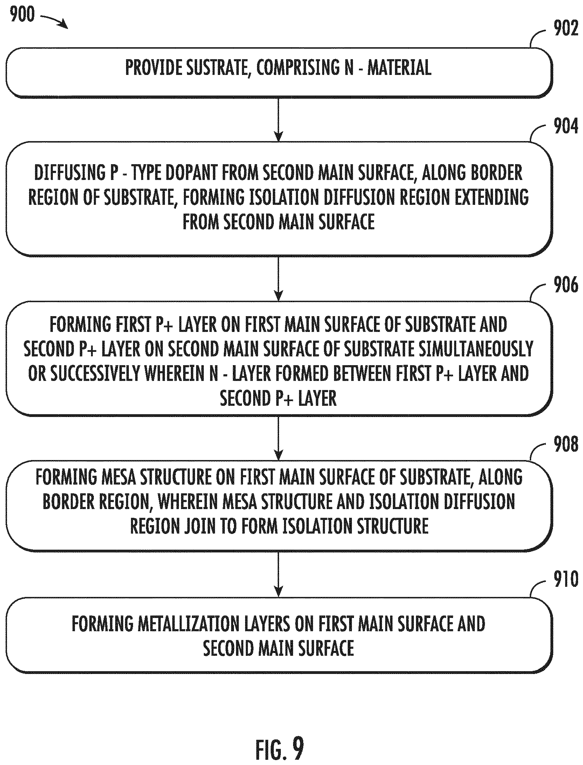

**FIG. 9** presents a further exemplary process flow 900. At block 902 a substrate is provided, where the substrate is formed of a N- material, meaning the substrate is a semiconductor material that is doped with a N-type dopant at a surface concentration in a range of 5E13 cm⁻³ - 1E15 cm⁻³.

At block 904, P-type dopant is introduced into and diffused from a second main surface of the substrate, forming an isolation diffusion region that extends into the substrate along a portion of the second main surface that represents a border region of the substrate. In one implementation, the border region may correspond to a surface pattern that defines the die or chip edges of a semiconductor wafer to be diced. As such, the border region may represent a region of a semiconductor substrate that extends above the side surfaces of semiconductor die after the die are cut from a wafer.

At block 906, a first P+ layer is formed on a first main surface of the substrate and a second P+ layer is formed on the second main surface of the substrate. In different embodiments, the formation of the second P+ layer may take place simultaneously or in succession with the formation of the first P+ layer. As such, an N- layer may be defined between the first P+ layer and the second P+ layer, where the N- layer represents an interior portion of the N- substrate. According to particular embodiments, the first P+ layer and may have a P-type dopant surface concentration in a range of 5E15 cm⁻³ -5E17 cm⁻³. The second P+ layer may have a P-type dopant surface concentration in a range of 1E17 cm⁻³ -1E21 cm⁻³.

At block 908 a mesa structure is formed on the first main surface of the substrate, along the border region, in a manner that the mesa structure and isolation diffusion region join to form an isolation structure. The isolation structure may encompass the first P+ layer and the N-layer to form a P+NP+ non punch through bidirectional TVS. The mesa structure may be a simple mesa structure or a two-step mesa structure in different embodiments. In particular embodiments of a two-step mesa structure, the first P+ layer formed in block 906 may require hundreds of times lower gradient of doping concentration with respect to simple mesa structure in order to achieve the effect to placement of the maximum field location away from the passivation and the resulting better forward blocking capability. This lower gradient is achievable using known dopants that have relatively higher diffusion coefficients.

At block 910, metal contact layers are formed on the first main surface and the second main surface, to form a first electrode contact in contact with the first P+ layer and a second electrode contact in contact with the second P+ layer.

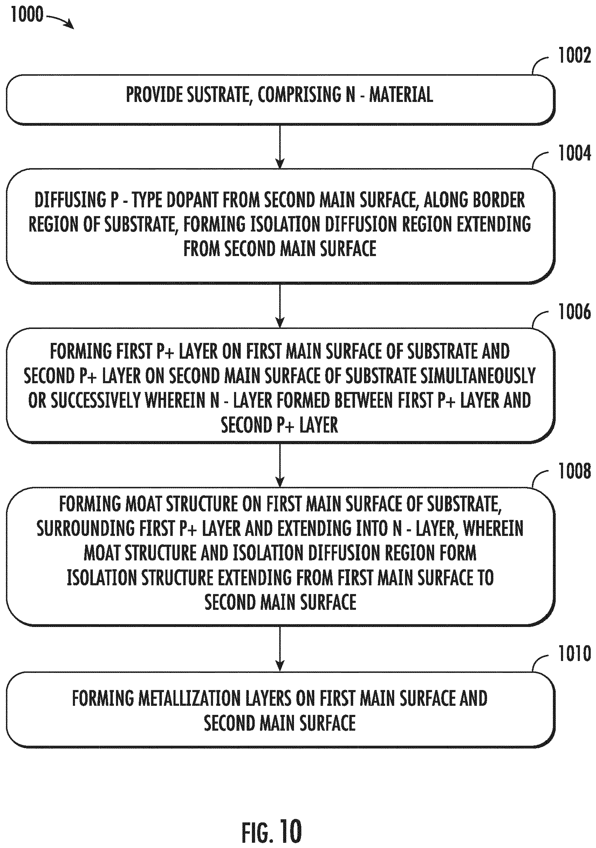

**FIG. 10** presents another exemplary process flow 1000. At block 1002 a substrate is provided, where the substrate is formed of a N- material, meaning the substrate is a semiconductor material that is doped with a N-type dopant at a surface concentration in a range of 5E13 cm⁻³ -1E15 cm⁻.

At block 1004, P-type dopant is introduced into and diffused from a second main surface of the substrate, forming an isolation diffusion region that extends into the substrate along a portion of the second main surface that represents a border region of the substrate. In one implementation, the border region may correspond to a surface pattern that defines the die or chip edges of a semiconductor wafer to be diced. As such, the border region may represent a region of a semiconductor substrate that extends above the side surfaces of semiconductor die after the die are cut from a wafer.

At block 1006, a first P+ layer is formed on a first main surface of the substrate and a second P+ layer is formed on the second main surface of the substrate. In different embodiments, the formation of the second P+ layer may take place simultaneously or in succession with the formation of the first P+ layer. As such, an N- layer may be defined between the first P+ layer and the second P+ layer, where the N- layer represents an interior portion of the N- substrate. According to particular embodiments, the first P+ layer and may have a P-type dopant surface concentration in a range of 5E15 cm⁻³ -5E18 cm⁻³. The second P+ layer may have a P-type dopant surface concentration in a range of 1E17 cm⁻³ -1E21 cm⁻³.

At block 1008, a moat structure is formed on the first main surface of the substrate, along the border region, in a manner that the moat structure and isolation diffusion region join to form an isolation structure. The isolation structure may encompass the first P+ layer and the N-layer to form a P+NP+ non punch through bidirectional TVS. In particular embodiments, the moat structure may be positioned such that the moat structure is inwardly displace toward with respect to the isolation diffusion region, such that a subsequent dicing process will define a side surface of a TVS chip that extends through the isolation diffusion region, but not through the moat structure.

At block 1010, metallization layers (metal contact layers) are formed on the first main surface and the second main surface, to form a first electrode contact in contact with the first P+ layer and a second electrode contact in contact with the second P+ layer.

While the aforementioned embodiments focus on P+NP+ non-punch through devices, in further embodiments, a N+PN+ non-punch through device may be formed according to the principles outlined in the aforementioned embodiments. For example, N+P-N+ structures analogous to the P+NP+ structures disclosed in FIGs. 4-6 may be especially suitable for fabricating non-punch through devices, due to the lower diffusion coefficient of applicable N-dopants in comparison to P-dopants.

While the present embodiments have been disclosed with reference to certain embodiments, numerous modifications, alterations and changes to the described embodiments are possible while not departing from the sphere and scope of the present disclosure, as defined in the appended claims. Accordingly, the present embodiments are not to be limited to the described embodiments, and may have the full scope defined by the language of the following claims, and equivalents thereof.

## Claims

1. A transient voltage suppression (TVS) device, comprising:
a first layer, disposed on a first surface of a substrate, comprising a first P+ layer;
a second layer, disposed on a second surface of the substrate, opposite the first surface, comprising a second P+ layer;
a third layer, disposed between the first P+ layer and the second P+ layer, comprising an N- layer; and
an isolation diffusion region, comprising a P structure, connected to the second P+ layer, and extending along a perimeter of the N- layer.

2. The TVS device of claim 1, wherein the first layer, the second layer, and the third layer form a non-punch through device having a negative dynamic resistance in reverse blocking mode.

3. The TVS device of claim 1 or 2, wherein the isolation diffusion region extends from the second surface to the first surface, wherein the first P+ layer extends over a first portion of the first surface, wherein the N- layer extends over a second portion of the first surface, and wherein the first P+ layer is electrically isolated from the isolation diffusion region.

4. The TVS device of any of the preceding claims, further comprising a mesa isolation region, extending from the first surface, and surrounding the first P+ layer, wherein the mesa isolation region is disposed in contact with the isolation diffusion region, preferably
wherein the mesa isolation region comprises a two-step mesa structure.

5. The TVS device of claim 4, wherein a first step of the mesa isolation region has a lower surface formed within the first P+ layer, and wherein a second step of the mesa isolation region has a lower surface formed within the N- layer.

6. The TVS device of any of the preceding claims, further comprising a moat isolation region, extending from the first surface into the N- layer, and surrounding the first P+ layer, wherein the moat isolation region is disposed in contact with the isolation diffusion region, and/or
wherein the isolation region forms an isolation diffusion edge termination for the TVS device.

7. An asymmetric bidirectional transient voltage suppression (TVS) device, comprising:
a semiconductor substrate, having a first main surface, a second main surface, opposite to the first main surface, and a set of side surfaces;
a first layer, disposed on the first main surface and comprising a first polarity;
a second layer, disposed on the second main surface and comprising the first polarity; and
a third layer, comprising a second polarity and being disposed within a bulk of the substrate, and being disposed between and in contact with the first layer and the second layer; and
an isolation diffusion region, comprising a doped material having the first polarity, the isolation diffusion region being disposed along the set of side surfaces, connected to the second layer, and extending along a perimeter of the third layer.

8. The asymmetric bidirectional TVS device of claim 7, wherein the first layer comprises a first P+ layer, the second layer comprises a second P+ layer, and the third layer comprises an N-layer wherein the first P+ layer, the second P+ layer, and the N- layer form a non-punch through device having a negative dynamic resistance in reverse blocking mode.

9. The asymmetric bidirectional TVS device of claim 8, wherein the isolation diffusion region extends from the second main surface to the first main surface, wherein the first P+ layer extends over a first portion of the first main surface, wherein the N- layer extends over a second portion of the first main surface, and wherein the first P+ layer is electrically isolated from the isolation diffusion region.

10. The asymmetric bidirectional TVS device of any of the claims 8 or 9 further comprising a mesa isolation region, extending from the first main surface, and surrounding the first P+ layer, wherein the mesa isolation region is disposed in contact with the isolation diffusion region, preferably
wherein the mesa isolation region comprises a two-step mesa structure.

11. The asymmetric bidirectional TVS device of claim 10, wherein a first step of the mesa isolation region has a lower surface formed within the first P+ layer, and wherein a second step of the mesa isolation region has a lower surface formed within the N- layer.

12. The asymmetric bidirectional TVS device of any of the claims 8-11, further comprising a moat isolation region, extending from the first main surface into the N- layer, and surrounding the first P+ layer, wherein the moat isolation region is disposed in contact with the isolation diffusion region, and is not in contact with the set of side surfaces.

13. The asymmetric bidirectional TVS device of any of the preceding claims 7-12, wherein the isolation diffusion region forms an isolation diffusion edge termination.

14. A method of forming an asymmetric bidirectional TVS device, comprising:
providing an N- substrate;
forming an isolation diffusion region along a perimeter of the N- substrate, comprising a P- material, by diffusing a P-type dopant from a second main surface of the N- substrate;
forming a first layer on a first main surface of the semiconductor substrate, comprising a first P+ layer; and
forming a second layer on a second main surface of the substrate, opposite the first main surface, comprising a second P+ layer, wherein an N- layer is formed between the first P+ layer and the second P+ layer, and
wherein the isolation diffusion region is electrically isolated from the first P+ layer.

15. The method of claim 14 with one or more of the following:
wherein the forming the first layer and the forming the second layer take place simultaneously;
further comprising forming an additional isolation structure, comprising a mesa isolation region or a moat isolation region, wherein the additional isolation structure extends from the first main surface, and surrounds the first P+ layer, and wherein the additional isolation structure is disposed in contact with the isolation diffusion region;
further comprising, exposing the N- substrate to a dose of electron irradiation, wherein a breakdown voltage of the asymmetric bidirectional TVS device is increased.
